# EUROPÄISCHE PATENTSCHRIFT

(11) **EP 0 968 522 B1**
(45) Veröffentlichungstag und Bekanntmachung des Hinweises auf die Patenterteilung: **02.05.2002**
(21) Anmeldenummer: 98914824.2
(22) Anmeldetag: 25.02.1998
(51) Int. Cl.: H01L 21/00, G01N 21/88

(54) **VERFAHREN ZUR ANWESENHEITSKONTROLLE VON ANSCHLUSSKUGELN**
METHOD OF CHECKING FOR THE PRESENCE OF CONNECTION BALLS
PROCEDE POUR VERIFIER LA PRESENCE DE BOULES DE CONNEXION

(30) Priorität: 05.03.1997 DE 19709003
(43) Veröffentlichungstag der Anmeldung: 05.01.2000
(73) Patentinhaber: SIEMENS AKTIENGESELLSCHAFT, 80333 München (DE)
(72) Erfinder: GRASMÜLLER, Hans-Horst, D-82291 Mammendorf (DE)
(86) Internationale Anmeldenummer: DE9800560
(87) Internationale Veröffentlichungsnummer: WO9839795

(56) Entgegenhaltungen:
- EP-A- 0 638 801
- US-A- 4 728 195
- PATENT ABSTRACTS OF JAPAN vol. 014, no. 263 (E-0938), 7.Juni 1990 -& JP 02 081449 A (HITACHI LTD), 22.März 1990,
- DATABASE WPI Section EI, Week 9825 Derwent Publications Ltd., London, GB; Class S02, AN 98-275561 XP002069811 "bump inspection apparatus for semiconductor chip" -& JP 10 089 927 A (FUJITSU) , 10.April 1998

## Beschreibung

Die Erfindung bezieht sich auf ein Verfahren zur Anwesenheitskontrolle von Anschlußkugeln von Bauelementen nach dem Oberbegriff des Patentanspruches 1. Ein Verfahren nach dem Oberbegriff des Anspruchs 1 ist aus JP-A-02 081 449 bekannt.

Bei der automatischen Bestückung von Substraten, insbesondere von Leiterplatten oder Keramiksubstraten, mit SMD-Bauelementen für die Oberflächenmontage (SMD = Surface Mounted Devices), werden die Bauelemente vor dem Aufsetzen visuell auf ihre Lage und das Vorhandensein aller Anschlüsse, insbesondere aller Anschlußkugeln im Fall von Ball Grid Arrays (BGA), überprüft, um anschließend die Position des Bauelementes vor dem Aufsetzen auf das Substrat zu korrigieren, oder das Bauelement wegen fehlender Anschlüsse auszusortieren.

Aus WO 96/21343 ist eine Vorrichtung zur Lageerkennung der Anschlüsse von Bauelementen bekannt, die eine Beleuchtung mit allseitig schräg einfallendem Licht benutzt, um die Reflexe von Anschlußkugeln automatisch auszuwerten und die Lage des Bauelements zu bestimmen, um anschließend eine Lagekorrektur durchführen zu können. Dabei wird eine segmentierte Ringlichtbeleuchtung verwendet, um alle Anschlußkugeln gleichmäßig von verschiedenen Seiten zu beleuchten.

Mit diesem Verfahren läßt sich allerdings nicht eindeutig bestimmen, ob alle Anschlußkugeln an den vorgesehenen Kontaktstellen vorhanden sind. Lötreste von der Befestigung der Kugeln können auch einen Reflex verursachen, der einem Reflex einer Anschlußkugel ähnlich sieht und eine anwesende Kugel vortäuscht. Die starke Abhängigkeit der Reflexposition von der Oberflächenbeschaffenheit der Anschlußkugeln erschwert die Auswertung zusätzlich.

Aus Ross,T. Townsend, A: Inspection technique for solder reflow pad height/volume, IBM Technical Disclosure Bulletin, Band 22, Nr. 9, Februar 1980, Seite 4068 ist ein Verfahren zur Bestimmung der Höhe oder des Volumens von Anschlußkugeln auf Bauelementen bekannt, wobei eine Bildauswerteeinheit die bei einer schräg einfallenden Beleuchtung resultierende Schattenfläche der Anschlußkugeln ermittelt. Die Beleuchtung erfolgt dabei nur einseitig, da bei einer allseitigen Beleuchtung keine auswertbaren Schattenflächen der Anschlußkugeln entstehen würden. Dunkle Verschmutzungen auf den Bauelementen in der Größe von Schattenflächen führen bei diesem Verfahren zu Fehlinterpretationen über das Vorhandensein von Anschlußkugeln.

Die Aufgabe der Erfindung besteht in der Entwicklung eines Verfahrens zur fehlerfreien Anwesenheitskontrolle von Anschlußkugeln an Bauelementen, insbesondere Ball Grid Arrays (BGA), unter besonderer Berücksichtigung der fehlerhaften Reflexe von Verschmutzungen (Lötresten) auf den nominell von Anschlußkugeln besetzten Plätzen.

Die Aufgabe wird erfindungsgemäß durch ein Verfahren mit den Merkmalen des Anspruchs 1 gelöst.

Bei einseitiger Beleuchtung der Anschlußkugeln mit parallelem oder von einer punktförmigen Lichtquelle emittiertem Licht werden die entstehenden Schatten und die Lichtreflexe der Anschlußkugeln ausgewertet. Dazu sind die von der Beleuchtungsrichtung und der Größe der Anschlußkugeln abhängigen Schattengrößen theoretisch oder experimentell zu ermitteln und mit den jeweils aktuell gemessenen Schattengrößen zu vergleichen. Dadurch wird zusätzlich der Einfluß der Oberflächenbeschaffenheit der Anschlußkugeln auf die Auswertung in vorteilhafter Weise vermieden. Durch die einseitige Beleuchtung entsteht in vorteilhafter Weise gegenüber dem aus der Stand der Technik bekannten Verfahren zur Messung der Lichtreflexe ein auswertbarer Schatten zur Anwesenheitskontrolle der Anschlußkugeln.

Ein weiterer Vorteil des Verfahrens besteht in der Möglichkeit, bereits bestehende Auswerteeinrichtungen zur Detektion des Lichtreflexes umzurüsten, wobei die Beleuchtungseinrichtung und die Bildauswerteeinheit übernommen werden. Die Bilderkennung wird dann entsprechend an das neue Verfahren angepaßt.

Durch die Detektion von Schatten und Reflex werden sowohl Lötreste, die fehlinterpretierbare Reflexe verursachen, wie auch dunkle Verunreinigungen in der Größe des Schattens von Anschlußkugeln, nicht fälschlicherweise als vorhandene Anschlußkugeln identifiziert. Dadurch ist eine fehlerfreie Anwesenheitskontrolle der Anschlußkugeln, unabhängig von deren Oberflächenbeschaffenheit, sichergestellt.

Eine erfindungsgemäße Ausgestaltung wird in der Zeichnung detaillierter erläutert, dabei zeigen
Figur 1 eine Vorrichtung zur Anwesenheitskontrolle von Anschlußkugeln im Längsschnitt,
Figur 2 eine Draufsicht auf ein seitlich beleuchtetes Bauelement mit den Schatten der Anschlußkugeln.

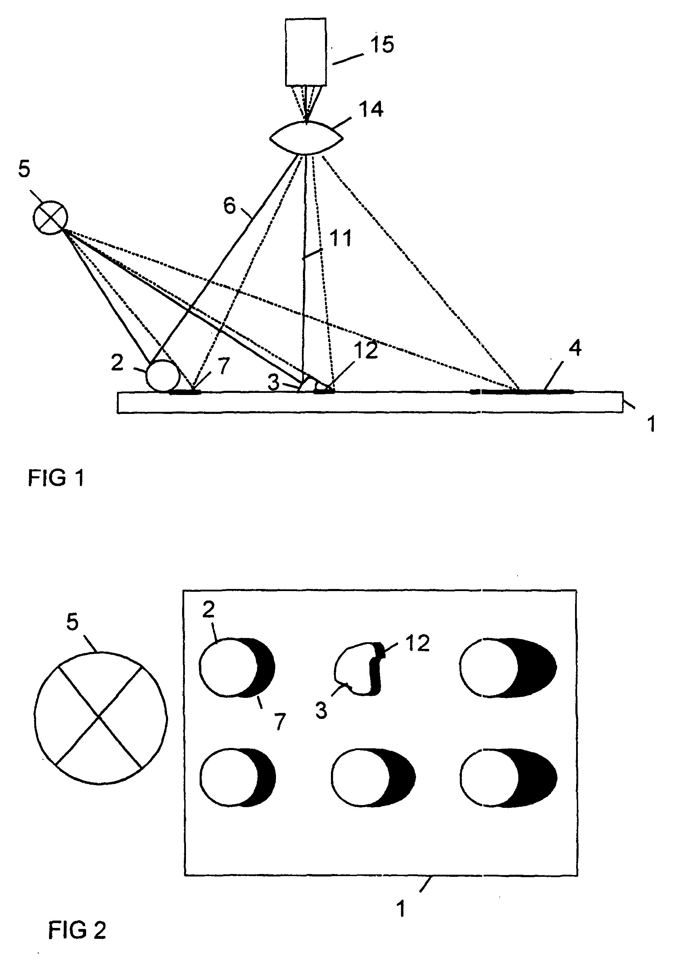

Figur 1 zeigt schematisch im Längsschnitt, wie ein Bauelement, hier ein Ball Grid Array 1, mit einer Anschlußkugel 2, einer metallischen Verschmutzung 3 sowie einer dunklen Verschmutzung 4 in der Größe des Schattens einer Anschlußkugel seitlich durch eine Lichtquelle 5 beleuchtet wird. Auch eine seitliche Beleuchtung mit parallelem Licht kann beim Verfahren verwendet werden. Besonders vorteilhaft ist die Verwendung einer segmentierten Ringlichtbeleuchtung, deren Segmente in ihrer Intensität einzeln steuerbar sind, so daß eine Beleuchtung mit einseitig schräg einfallendem Licht erzielt wird.

Die Anschlußkugel 2 erzeugt einen Reflex 6 und einen Schatten 7, die metallische Verschmutzung 3 einen weiteren Reflex 11 und einen weiteren Schatten 12, die - wie auch eine dunkle Verschmutzung 4 in der Größe des Schattens einer Anschlußkugel - über ein Objektiv 14 auf eine Bildauswerteeinheit 15, beispielsweise eine CCD-Kamera, abgebildet werden. Der weitere Schatten 12 der metallischen Verschmutzung 3 unterscheidet sich in seiner Größe vom Schatten einer Anschlußkugel, die an der Stelle der metallischen Verschmutzung vorgesehen war, was mit Hilfe der Bildauswerteeinheit 15 erlaubt, den fehlenden Kontakt zu identifizieren und das Bauelement auszusortieren. Die dunkle Verschmutzung 4 in der Größe des Schattens einer Anschlußkugel läßt sich durch das Fehlen eines zur dunklen Verschmutzung 4 gehörigen zusätzlichen Reflexes mit Hilfe der Bildauswerteeinheit 15 identifizieren.

In Figur 2 ist das seitlich beleuchtete Bauelement 1 mit mehreren Anschlußkugeln 2 mit den zugehörigen Schatten 7 sowie die metallische Verschmutzung 3 mit dem zugehörigen weiteren Schatten 12 aus der Richtung der Bildauswerteeinheit 15 dargestellt. Der weitere Schatten 12 der metallischen Verschmutzung 4 unterscheidet sich von einem zu erwartenden Schatten einer Anschlußkugel, was durch die Bildauswerteeinheit 15 erkannt wird.

## Patentansprüche

1. Verfahren zur Anwesenheitskontrolle von Anschlußkugeln (2) auf Bauelementen, insbesondere auf Ball Grid Arrays (1),
wobei die Anschlußkugeln (2) mit aus einer Richtung schräg einfallendem Licht beleuchtet werden,
wobei Lichtreflexe der Anschlußkugeln (2) durch eine einer abbildenden Optik (14) nachgeschaltete Bildauswerteeinheit (15) detektiert werden und
wobei ein durch das schräg einfallende Licht resultierender Schatten (7) seitlich der Anschlußkugeln (2) durch die Bildauswerteeinheit (15) ausgewertet wird,
**dadurch gekennzeichnet, daß** die Größe des bei einer bestimmten Größe der Anschlußkugel (2) zu erwartenden Schattens (7) bei gleichzeitiger Anwesenheit des zugehörigen Lichtreflexes (6) der Anschlußkugel (2) als Kriterium zur automatischen Anwesenheitskontrolle von Anschlußkugeln (2) genutzt wird.

## Claims

1. Method of checking for the presence of connection balls (2) on components, in particular on ball grid arrays (1),
where the connection balls (2) are illuminated by light which is obliquely incident from one direction,
where light reflections from the connection balls (2) are detected by an image-evaluating unit (15) connected downstream of an imaging optical arrangement (14), and
where a shadow (7) cast laterally with,respect to the connection balls (2) and resulting due to the obliquely incident light is evaluated by the image-evaluating unit (15),
**characterized in that** the size of the shadow (7) to be expected given a specific size of the connection ball (2), in conjunction with the presence of the associated light reflection (6) from the connection ball (2), is used as a criterion for automatically checking for the presence of connection balls (2).

## Revendications

1. Procédé pour contrôler la présence de boules de connexion (2) sur des composants, en particulier des matrices à grille de boules (Ball Grid Arrays) (1),
dans lequel les boules de connexion (2) sont éclairées par une lumière en incidence oblique provenant d'une direction donnée,
dans lequel les faisceaux réfléchis par les boules de connexion (2) sont détectés par une unité d'évaluation d'image (15), montée en aval d'une optique de formation d'image (14), et
dans lequel une ombre (7), due à la lumière en incidence oblique, et en position latérale par rapport aux boules de connexion (2), est évaluée par l'unité d'évaluation d'image (15),
**caractérisé en ce qu'**on utilise en tant que critère pour le contrôle automatique de la présence de boules de connexion (2) la taille de l'ombre (7), à laquelle on peut s'attendre pour une certaine taille des boules de connexion (2), en présence simultanée du faisceau réfléchi correspondent (7) par la boule de connexion (2).
